# EUROPEAN PATENT APPLICATION

(11) **EP 2 426 083 A2**
(43) Date of publication of application: **07.03.2012**
(21) Application number: 10186649.9
(22) Date of filing: 06.10.2010
(51) Int. Cl.: B81B 7/00

(54) **Mems sensor package**

(30) Priority: 03.09.2010 TW 99129897
(71) Applicant: Domintech Co., LTD., Wugu Township, Taipei County 248 (TW)
(72) Inventor: Wu, Ming-Ching, 248, TAIPEI COUNTY (TW); Huang, Chin-Kung, 248, TAIPEI COUNTY (TW)
(74) Representative: Becker Kurig Straus

(57) **Abstract**

A MEMS sensor package (10) includes a support (12) and a MEMS sensor chip (14) having a mounting side (16) adhered on the support by a point-shaped adhesive (20) or a linear-shaped adhesive (20) in such a way that the MEMS sensor chip has a free side (18) opposite to the mounting and suspended above the support (12). Because the MEMS sensor chip has the free side that is not restrained on the support, the stress due to deformation of the support will not affect the accuracy of the MEMS sensor chip.

## Description

### BACKGROUND OF THE INVENTION

### 1. Field of the Invention

The present invention relates generally to a sensor package of a micro-electro-mechanical system (hereinafter referred to as "MEMS") and more particularly, to a MEMS sensor package having a MEMS sensor chip adhered on a support by a point-shaped adhesive or a linear-shaped adhesive in such a way that the MEMS sensor chip has a free side suspended above the support.

### 2. Description of the Related Art

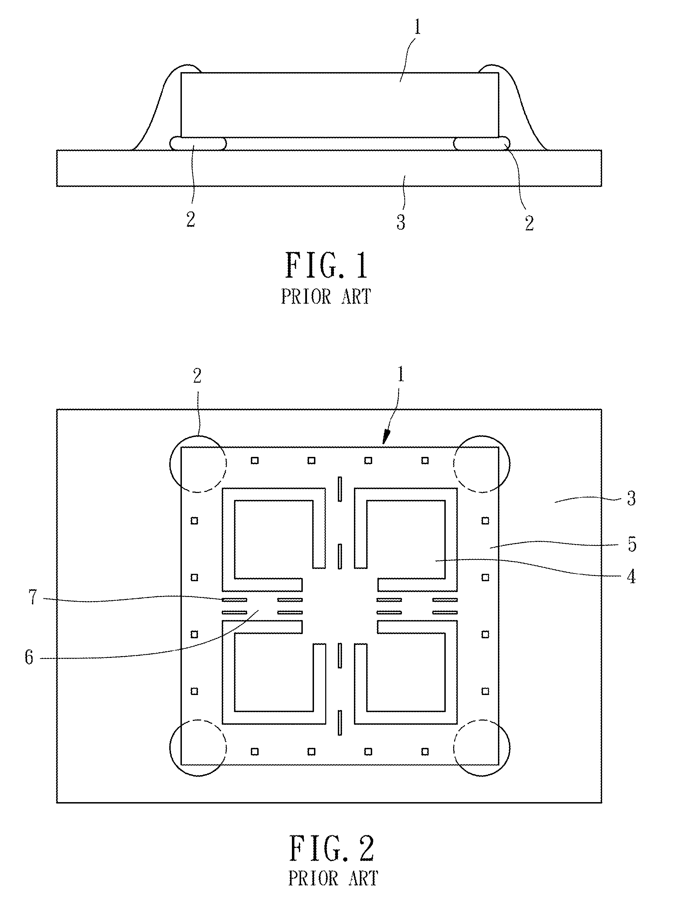

In a conventional integrated circuit (hereinafter referred to as "IC") chip package, the bottom of the IC chip is entirely adhered on a support, such as a lead frame or a printed circuit board, by adhesive in order to firmly and stably support the IC chip. As for a MEMS sensor chip package including a MEMS sensor chip having a moveable sensing element, a part of the bottom of the MEMS sensor chip, which corresponds in location to the moveable sensing element, is suspended above a support on which the MEMS sensor chip is adhered. Taking a conventional piezo-resistive three-axis accelerometer shown in FIGS. 1-2 for example, the sensor chip **1** is adhered on a support **3** through adhesives **2** disposed at four corners of a bottom surface of a frame **5** of the sensor chip **1,** such that the moveable sensing element **4** of the sensor chip **1** is suspended above the support **3.** In this way, the moveable sensing element **4** is moveable relative to the frame **5** of the sensor chip **1** when the moveable sensing element **4** receives an external force. Specifically speaking, the moveable sensing element **4** is indirectly connected with the frame **5** through four flexible bridges **6** on which a plurality of resistances **7** are arranged. Since the movement of the moveable sensing element **4** can cause stress-strain to the bridges **6,** which results in change of resistance values of the resistances 7, the change of the external force can be indirectly detected by means of detecting the value changes of the resistances representing the stress-strain variation. It is to be mentioned that the detailed structure and operation principle of the aforesaid conventional accelerometer are well disclosed in prior arts including but not limited to US patent No. 4,905,523.

In the above-mentioned MEMS sensor package, in a case the support **3** expends or contracts in dimension in response to change of the ambient or working temperature, because the sensor chip **1** is restrained on the support **3,** the deformation stress of the support **3** will distribute to the sensor chip **1** and then affect values of the resistances **7** to further cause a measurement error of the sensor chip **1.** In order to resolve this problem, adhesive materials having specific viscosity and temperature resistance for absorbing the deformation stress of the support are developed. However, these specific adhesive materials have a limited effect and usually have a deterioration problem after long-term use.

### SUMMARY OF THE INVENTION

The present invention has been accomplished in view of the above-noted circumstances. It is therefore an object of the present invention to provide a MEMS sensor package, which can prevent the measurement error of the MEMS sensor chip due to deformation of the support.

It is another object of the present invention to provide a MEMS sensor package, which needs not to use an adhesive material having a specific viscosity and a temperature resistance between the MEMS sensor chip and the support.

To attain the above-mentioned objects, the MEMS sensor package provided by the present invention comprises a support and a MEMS sensor chip. The MEMS sensor chip is adhered on the support in such a way that the MEMS sensor chip has a free side suspended above the support. Because the MEMS sensor chip has the free side that is not restrained on the support adhesively or mechanically, the measurement accuracy of the MEMS sensor chip will not be affected by deformation of the support, thereby avoiding the measurement error due to the deformation of the support. For this reason, a general adhesive can be used for adhering the MEMS sensor chip on the support. In other words, it is not necessary to use an adhesive material having a specific range of viscosity and/or a specific temperature resistance to absorb the deformation stress of the support.

In a preferred embodiment of the present invention, the MEMS sensor chip is provided with a mounting side, which is opposite to the free side and adhered on the support by at least one point-shaped adhesive. Preferably, the mounting side of the MEMS sensor chip is adhered on the support by, but not limited to, two point-shaped adhesives provided respectively at two corners of the mounting side. In an alternate form of the MEMS sensor package of the present invention, the mounting side of the MEMS sensor chip is adhered on the support by a linear-shaped adhesive.

For the MEMS sensor chip, any suitable MEMS sensor chip including but not limited to a piezo-resistive or capacity type acceleration sensing chip can be used in the present invention. For example, in a preferred embodiment of the present invention, the MEMS sensor chip is realized by a three-axis acceleration sensing chip of piezo-resistive type, which comprises a frame having the free side, a plurality of flexible bridges extending from the frame towards a center of the frame, and a moveable sensing element, which is so-called "proof mass" and connected with the bridges in such a way that the moveable sensing element is moveably suspended inside the frame. In practice, the MEMS sensor chip adapted to be used in the present invention is not limited to an acceleration sensing chip. Any MEMS sensor chip having a moveable sensing element or a part of the bottom thereof to be suspended above a support on which the MEMS sensor chip is adhered can be used in the present invention.

In the above-mentioned MEMS sensor chip package of the present invention, the support can be, but not limited to, a printed circuit board. For example, in a preferred embodiment of the present invention, the support is realized by an application-specific integrated circuit (hereinafter referred to as "ASIC") chip for signal processing. The ASIC chip served as the support is electrically connected with the MEMS sensor chip and provided with a bottom side that is bonded on a printed circuit board.

In another preferred embodiment, the support is realized by a printed circuit board and an ASIC chip is bonded on the MEMS sensor chip in a way that the free side of the MEMS sensor chip is suspended between the support and the ASIC chip. In addition, a spacer is supported between the support and the ASIC chip so as to enhancing the structural strength of the package.

### BRIEF DESCRIPTION OF THE DRAWING

The present invention will become more fully understood from the detailed description given herein below and the accompanying drawings which are given by way of illustration only, and thus are not limitative of the present invention, and wherein:
FIG. 1 is a schematic side view of a MEMS sensor package according to a prior art;
FIG. 2 is a top view of the MEMS sensor package shown in FIG. 1, wherein the bonding wires are removed for concise illustration;
FIG. 3 is schematic side view of a MEMS sensor package according to a first preferred embodiment of the present invention;
FIG. 4 is a top view of the MEMS sensor package shown in FIG. 3, wherein the bonding wires are removed for concise illustration;
FIG. 5 is a sectional view taken along line 5-5 of FIG. 4;
FIG. 6 is a schematic top view showing that the MEMS sensor chip is adhered on the support by a point-shaped adhesive;
FIG. 7 is a schematic top view showing that the MEMS sensor chip is adhered on the support by a linear-shaped adhesive;
FIG. 8 is a schematic side view of a MEMS sensor package according to a second preferred embodiment of the present invention; and
FIG. 9 is a schematic side view of a MEMS sensor package according to a third preferred embodiment of the present invention.

### DETAILED DESCRIPTION OF THE INVENTION

It is to be firstly mentioned that the same numeral references used in the following paragraphs and the drawings refer to the same or similar elements and/or structural features.

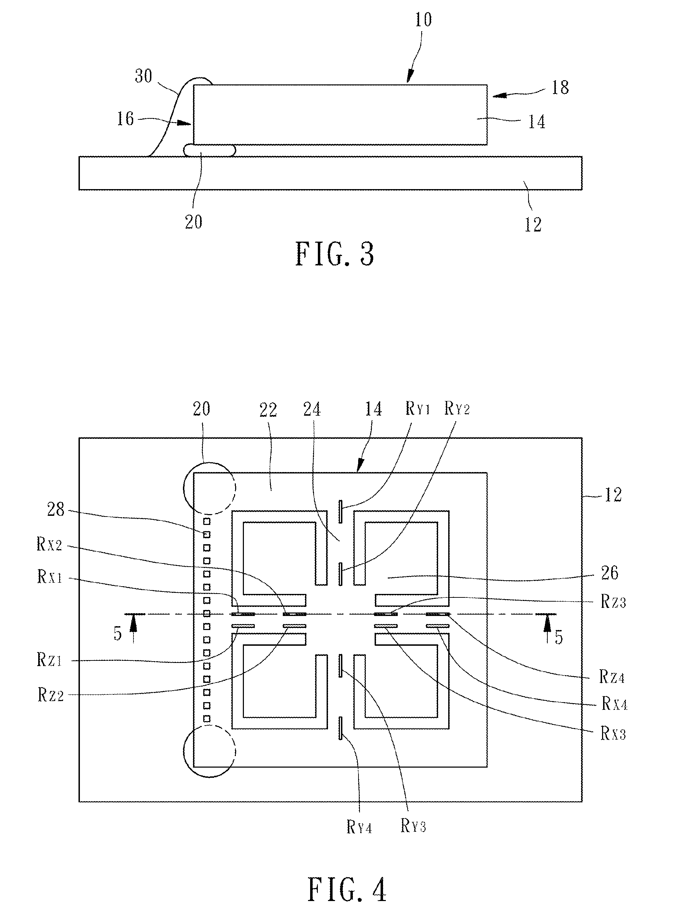

According to a first preferred embodiment of the present invention, a MEMS sensor package, denoted by numeral reference **10,** mainly comprises a support **12** and a MEMS sensor chip **14,** as shown in FIGS. 3-5.

The support **12** is adapted to mechanically support and electrically connect the MEMS sensor chip **14.** In this preferred embodiment, a printed circuit board, which is provided at a surface thereof with a circuit pattern (not shown) for electrical connection with the MEMS sensor chip **14,** is used as the support **12.**

The MEMS sensor ship **14** has a first side **16** and a second side **18** opposite to the first side **16.** Each of two corners at a bottom side of the first side **16** of the MEMS sensor chip **14** is adhered on a top surface of the support **12** by a point-shaped adhesive **20** in such a way that the first side **16** becomes a mounting side connected and restrained on the support **12** and the second side **18** forms a free side that is not restrained on the support **12** but suspended above the support **12.** It will be appreciated that the term "free side" used in this written description and the appendix claims means a side that is not connected with the support **12** adhesively and/or mechanically, such that the side is free to move without being restrained by the support **12.**

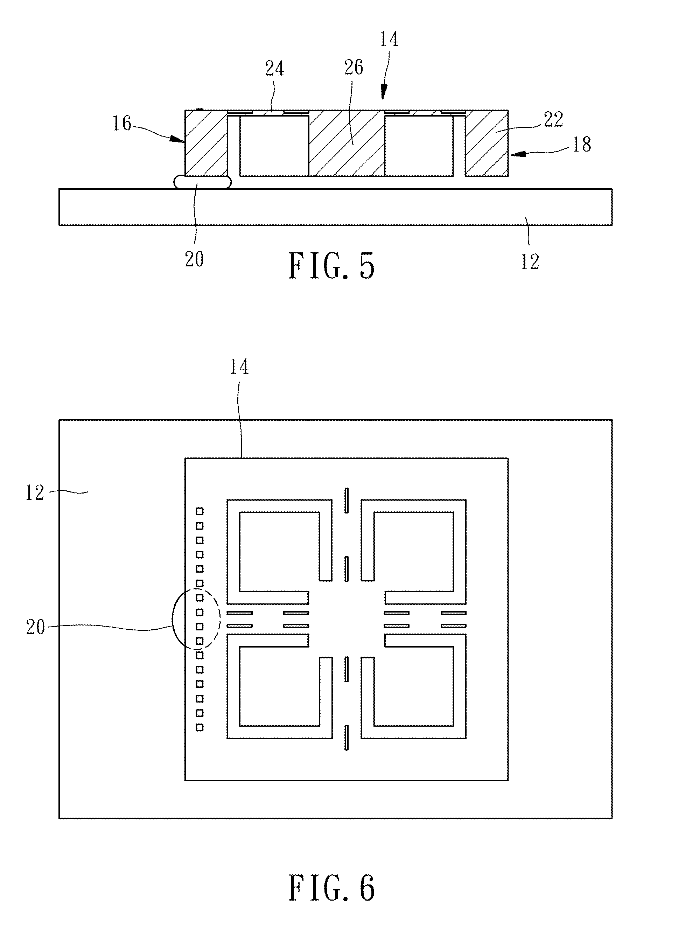

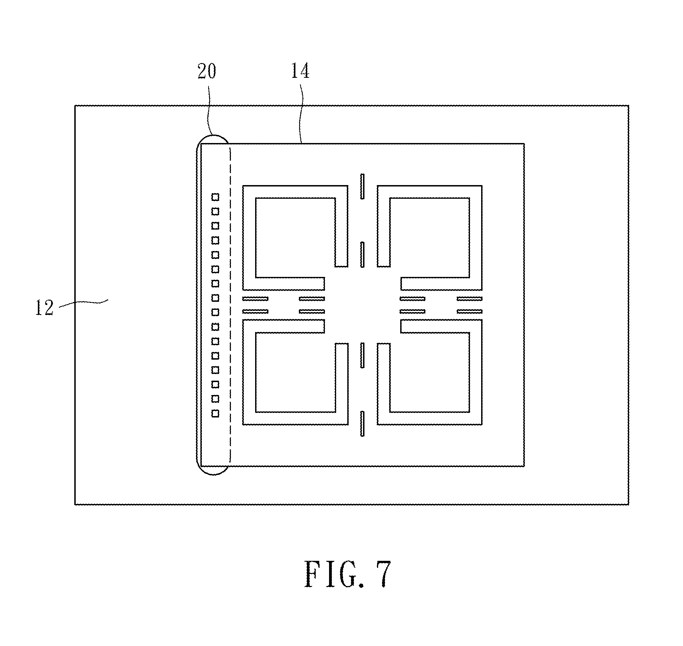

In this preferred embodiment, forming the second side **18** into the free side is realized by a way of using two point-shaped adhesives **20** to connect the MEMS sensor chip **14** with the support **12.** This way is however an example only, not a limitation. For example, the mounting side **16** of the MEMS sensor chip **14** can be adhered at a middle thereof on the support **12** by only one point-shaped adhesive **20** as shown in FIG. 6. Alternatively, the mounting side **16** of the MEMS sensor chip **14** can be adhered on the support **12** by a linear-shaped adhesive **20** as shown in FIG. 7. By any of aforesaid ways, the purpose of forming the free side at the MEMS sensor chip **14** can be achieved.

For the adhesive **20** adapted for adhering the MEMS sensor chip **14** on the support **12,** a conventional adhesive, including but not limited to an epoxy-based or polyimide-based adhesive, can be used.

Referring to FIGS. 4-5 again, in this preferred embodiment the MEMS sensor chips **14** is a three-axis acceleration sensing chip of piezo-resistive type, which has a rectangular frame **22,** four flexible bridges **24** each extending from a middle of one side of the frame **22** towards a center of the frame **22,** and a moveable sensing element **26,** which is so-called "proof mass." The moveable sensing element **26** is connected with the four bridges **24** such that the moveable sensing element **26** is suspended inside the frame **22** and moveable relative to the frame **22** when the moveable sensing element **26** receives an external force. On the top surfaces of the bridges **24,** three sets of resistances, i.e. resistances R_{X1} to R_{X4}, resistances R_{Y1} to R_{Y4} and resistances R_{Z1} to R_{Z4}, are arranged. Since the structure and operation principle of the accelerometer of this kind are well-known to a person skilled in the arts including but not limited to US patent No. 4,905,523, a detailed description thereof needs not to be recited hereinafter.

In addition, a plurality of bonding pads **28** for signal input/output are arranged on a top surface of the mounting side **16.** By means of bonding wires **30** respectively connecting the bonding pads **28** with the support **12,** the MEMS sensor chip **14** is electrically connected with the support **12.** However, it will be appreciated that the way of electrically connecting the MEMS sensor chip **14** to the support **12** is not limited to wire bonding technology. Any suitable way, including but not limited to flip chip technology, can be used.

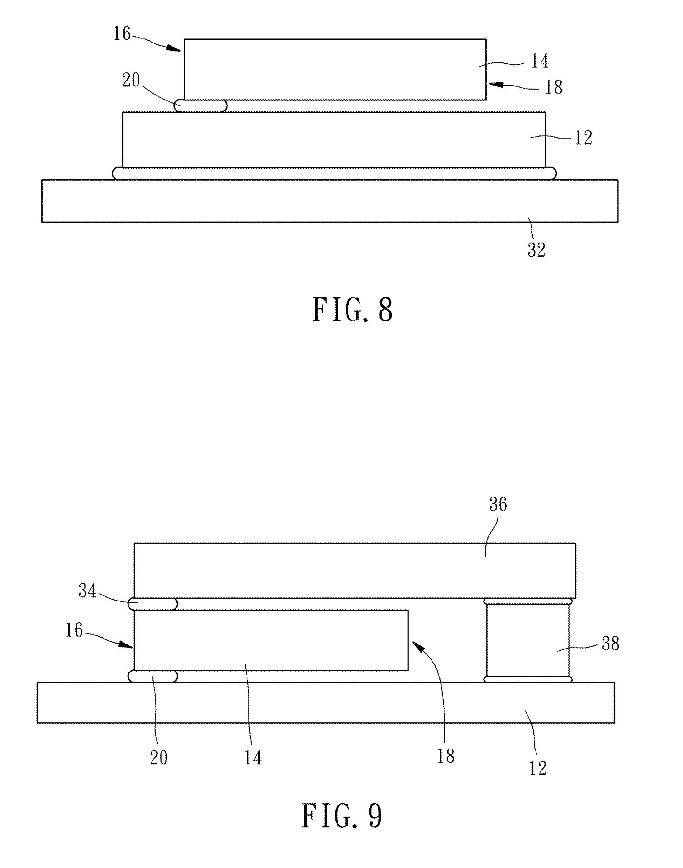

In the above-mentioned preferred embodiment, the support **12** is realized by a printed circuit board. However, the support **12** can be other forms according to the actual need. For example, FIG. 8 shows a MEMS sensor package according to a second preferred embodiment of the present invention, in which the support **12** is realized by an ASIC chip. As shown in FIG 8, the mounting side **16** of the MEMS sensor chip **14** is adhered on a top surface of the ASIC chip such that a free side **18** is formed and suspended above the ASIC chip, i.e. the support **12.** In addition, the bottom side of the ASIC chip is bonded on a printed circuit board **32.** The electrical connection between the MEMS sensor chip and the ASIC chip or between the ASIC chip and the printed circuit board can be achieved by bonding wires (not shown) or any suitable way.

FIG. 9 shows a MEMS sensor package according to a third preferred embodiment of the present invention. In this embodiment, the support **12** for supporting the MEMS sensor chip **14** is a printed circuit board. An ASIC chip **36** is adhered on a top surface of the mounting side **16** of the MEMS sensor chip **14** by a point-shaped adhesive or a linear-shaped adhesive, such that the free side **18** of the MEMS sensor ship **14** is suspended between the support **12** and the ASIC chip **36.** To enhance the structural strength of the package and to enable the free side **18** of the MEMS sensor ship **14** to be stably suspended between the support **12** and the ASIC chip **36,** a spacer **38** is adhesively supported between the support **12** and the ASIC chip **36.** For the electrical connection between the MEMS sensor chip **14** and the ASIC chip **36** or between the MEMS sensor chip **14** and the support **12,** bonding wires (not shown) or any suitable way can be used.

In conclusion, the MEMS sensor package of the present invention is characterized in that the four sides of the bottom surface of the MEMS sensor chip are not totally adhered and restrained on the support, but only one side, i.e. the mounting side, is adhered on the support. Since the MEMS sensor chip has a free side that is not restrained on the support, the accuracy of the MEMS sensor chip will not be affected by the deformation of the support. As a result, a general adhesive, which needs not to have a specific range of viscosity and/or a specific temperature resistance, can be used to adhere the MEMS sensor chip on the support.

## Claims

1. A MEMS sensor package (10) comprising a support (12) and a MEMS sensor chip (14) on the support, the MEMS sensor packing being **characterized in that** the MEMS sensor chip (14) is adhered on the support (12) and has a free side (18) suspended above the support (12).

2. The MEMS sensor package as claimed in claim 1, **characterized in that** the MEMS sensor chip (14) has a mounting side (16) opposite to the free side (18) and adhered on the support (12) by at least one point-shaped adhesive (20).

3. The MEMS sensor package as claimed in claim 2, **characterized in that** the mounting side (16) of the MEMS sensor chip has two corners, each of which is adhered on the support by one said point-shaped adhesive (20).

4. The MEMS sensor package as claimed in claim 1, **characterized in that** the MEMS sensor chip has a mounting side (16) opposite to the free side (18) and adhered on the support by a linear-shaped adhesive (20).

5. The MEMS sensor package as claimed in claim 1, **characterized in that** the MEMS sensor chip (14) comprises a frame (22) having the free side (18), a plurality of flexible bridges (24) extending from the frame towards a center of the frame, and a moveable sensing element (26) connected with the flexible bridges such that the moveable sensing element is suspended inside the frame.

6. The MEMS sensor package as claimed in claim 5, **characterized in that** the frame of the MEMS sensor chip has a mounting side (16) opposite to the free side and adhered on the support by at least one point-shaped adhesive (20).

7. The MEMS sensor package as claimed in claim 6, **characterized in that** the mounting side (16) of the frame (22) of the MEMS sensor chip has two corners, each of which is adhered on the support by one said point-shaped adhesive (22).

8. The MEMS sensor package as claimed in claim 5, **characterized in that** the frame (22) of the MEMS sensor chip (14) has a mounting side (16) opposite to the free side (18) and adhered on the support (12) by a linear-shaped adhesive (20).

9. The MEMS sensor package as claimed in any one of claims 1 to 8, **characterized in that** the support (12) is a printed circuit board.

10. The MEMS sensor package as claimed in claim 9, **characterized in that** the MEMS sensor package further comprises:
an ASIC chip (36) bonded on the MEMS sensor chip (14) in a way that the free side (18) of the MEMS sensor chip is suspended between the printed circuit board and the ASIC chip; and
a spacer (38) supported between the printed circuit board and the ASIC chip.

11. The MEMS sensor package as claimed in any one of claims 1 to 8, **characterized in that** the support (12) is an ASIC chip having a bottom side bonded on a printed circuit board (32).
